# EUROPEAN PATENT SPECIFICATION

(11) **EP 0 627 622 B1**
(45) Date of publication and mention of the grant of the patent: **17.10.2001**
(21) Application number: 94303823.2
(22) Date of filing: 26.05.1994
(51) Int. Cl.: G01N 27/62

(54) **An ion current detector device for use in an internal combustion engine**
Ionisierungsfühler für Verbrennungsmotoren
Détecteur à ionisation pour moteur à combustion interne

(30) Priority: 31.05.1993 JP 12953493; 31.05.1993 JP 12979693
(43) Date of publication of application: 07.12.1994
(73) Proprietor: NGK SPARK PLUG CO., LTD, Nagoya-shi (JP)
(72) Inventor: Matsubara, Yoshihiro, Mizuho-Ku, Nagoya-shi (JP); Kodera, Mamoru, Mizuho-Ku, Nagoya-shi (JP); Ishikawa, Masahiro, Mizuho-Ku, Nagoya-shi (JP); Tomita, Terumasa, Mizuho-Ku, Nagoya-shi (JP)
(74) Representative: Senior, Alan Murray

(56) References cited:
- FR-A- 2 433 105
- GB-A- 2 131 177
- US-A- 2 523 017

## Description

This invention relates to an ion current detector device which measures an ion current in an inside of a cylinder or an exhaust passage of an internal combustion engine so as to detect its burning conditions such as a misfire.

In an ion current detector device for an internal combustion engine, an ion current detector electrode and ion current electrode have been arranged to be exposed inside a cylinder or an exhaust passage of an internal combustion engine. Several hundred volts are applied across the two electrodes to detect the intensity of electric current caused by ionized particles in burning gas of an air-fuel mixture of exhaust gas.

In this type of the ion current detector device, the intensity of ion current is detected between the engine body and a common electrode connected to an ion current power source circuit and an ion current detector circuit. This makes the ion current detector circuit more complicated thereby reducing reliability and increasing costs when putting the device into the internal combustion engine as a practical use.

GB-A-2 131 177 and US-A-2 523 017 disclose ion current detector devices similar to the conventional device described above. US-A-2 523 017 forms the basis of the pre-characterizing portion of claim 1.

Therefore, it is one of the objects of the invention to provide an ion current detector device which is capable of structurally simplifying an ion current detector circuit, and manufacturing it at low cost with high reliability.

According to one aspect of the present invention, there is provided an ion current detector device for an internal combustion engine, comprising:
an ion voltage electrode provided so that in use its front end is exposed to an inside of a cylinder or an exhaust passage of an internal combustion engine;
an ion current power source which is connected to the ion voltage electrode; and
an ion current detector circuit,
characterised in that:
a plurality of ion current detector electrodes are circumferentially arranged with the ion voltage electrode at a central portion, and forming ion current gaps with the front end of the ion voltage electrode; and
wherein said ion current detector circuit is connected between said ion current detector electrodes and ground, and comprises a voltage detector circuit provided between the ion current detector electrodes and a resistor which is connected between each ion current detector electrode and the ground, so as to detect an intensity of current flowing through the resistor and the ion current detector electrodes.

With the use of the ion current detector circuit having the resistor and the voltage detector circuit, each connected between the ion current detector electrodes and the ground, it is possible to structurally simplify the ion current detector circuit, and reduce cost with easy maintenance.

With a plurality of ion current detector electrodes circumferentially arranged with the ion voltage electrode as a central portion, it is possible to detect the intensity of ion current with high accuracy, and detecting the direction in which combustion flames spread in the cylinder of the internal combustion engine.

Preferably, the ion current detector electrodes are provided in a spark plug slantwisely with respect to a center electrode, the front ends of the ion current detector electrodes forming ion current gaps with a front end of the center electrode.

Preferably, said ion voltage electrode is the center electrode of a spark plug to be connected to an ignition circuit which acts as said ion current power source, the spark plug being for location in a cylinder of an internal combustion engine.

In the presence of the ionized particles between the center electrode and the ion current detector electrodes upon completing the normal combustion in the cylinder of the internal combustion engine, the ionized particles causes to decrease an electrical resistance of the ion current gap between the electrodes. This makes it possible to induce an ion current jumping the gap to flow to the center electrode by way of the ion current detector circuit and the ion current detector electrodes. As a result, an intensity of the ion current is measured by the ion current detector circuit without particularly providing an ion current power source, and thus enabling to detect burning condition such as misfire in the cylinder of the internal combustion engine with a simplified circuit.

With the ion current detector having a resistor connected between the ion current detector electrodes and the ground, and a voltage detector circuit which detects an intensity of current flowing through the resistor and the ion current detector electrodes, it is possible to simplify the ion current detector circuit, and produce it with low cost.

Preferably, a diode is connected between the center electrode of the spark plug and an ignition circuit so as to prevent a reverse polarity spark plug voltage affecting ion current detection.

With the high voltage diode connected between the center electrode of the spark plug and the ignition circuit so as to prevent current flowing back to the ignition circuit, it is possible to avoid a reverse-polarity ion current from occurring in the ion current detector circuit so as to enable a highly accurate detection, while at the same time, insuring a high ignition voltage can be applied to the spark plug.

These and other objects and advantages of the invention will be apparent upon reference to the following specification, attendant claims and drawings In order that the invention may be better understood, the following description is given with reference to the accompanying drawings in which:
Fig. 1 is a schematic view of an ion current detector device to assist understanding of the invention;
Figs. 2a and 2b are graphical representations characteristic of an ion current;
Fig. 3a is a schematic view of an ion current detector device according to a first embodiment of the invention;
Fig. 3b is a bottom plan view of the ion current detector device looked from the line 3I - 3I of Fig. 3a;
Fig. 4 is a schematic view of an ion current detector device incorporated into an internal combustion engine to assist understanding of the invention;
Fig. 5 is a plan view of a spark plug to assist understanding of the invention, but its left half is sectioned.
Figs. 6a and 6b are graphs characteristic of an ion current;
Fig. 7a is a longitudinal cross sectional view of an ion current detector device according to a second embodiment of the invention; and
Fig. 7b is a bottom plan view of the ion current detector device looked from the line 7A - 7A of Fig. 7a.

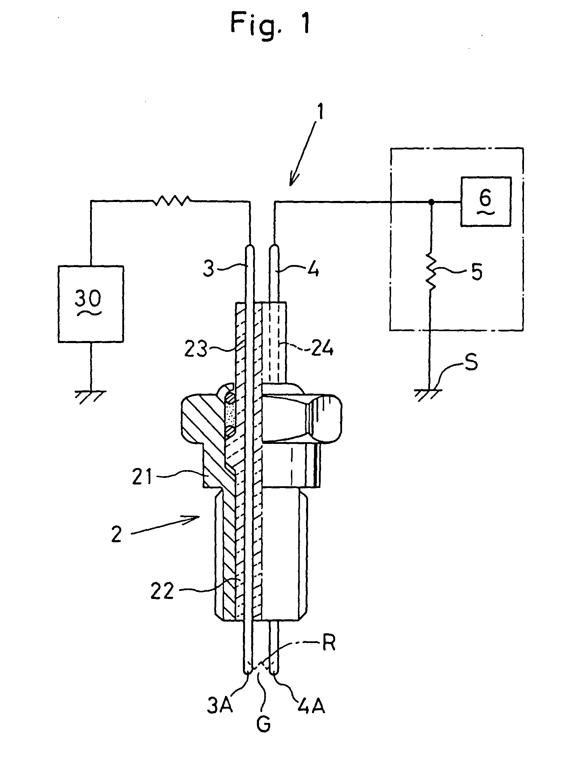

Referring to Fig. 1 which shows an ion current detector device 1 used for an internal combustion engine, numeral 2 designates an ion plug which is incorporated into a cylinder head (not shown) of the internal combustion engine. The ion plug 2 has a metallic shell 21 in which an elongated insulator 22 is placed. In the insulator 22, axial bores 23, 24 are provided in parallel with each other. Within the axial bore 23, an ion voltage electrode 3 is tightly placed to be electrically connected to a D.C. or A.C. type current power source 30 (several ten to hundred voltage), while an ion current detector electrode 4 is firmly placed within the axial bore 24 so as to form an ion current gap G between a front end 3A of the former electrode 3 and a front end 4A of the latter electrode 4. In this instance, both the front ends 3A, 4A of the electrodes 3, 4 are directly exposed to an inside of a cylinder of the internal combustion engine. The front ends 3A, 4A of the electrodes 3, 4 may be straightly exposed to an exhaust passage through which an exhaust gas passes from the cylinder of the internal combustion engine.

Meanwhile, a resistor 5 is provided between the ion current detector electrode 4 and the ground S, and a voltage detector circuit 6 is provided between the resistor 5 and the ion current detector electrode 4.

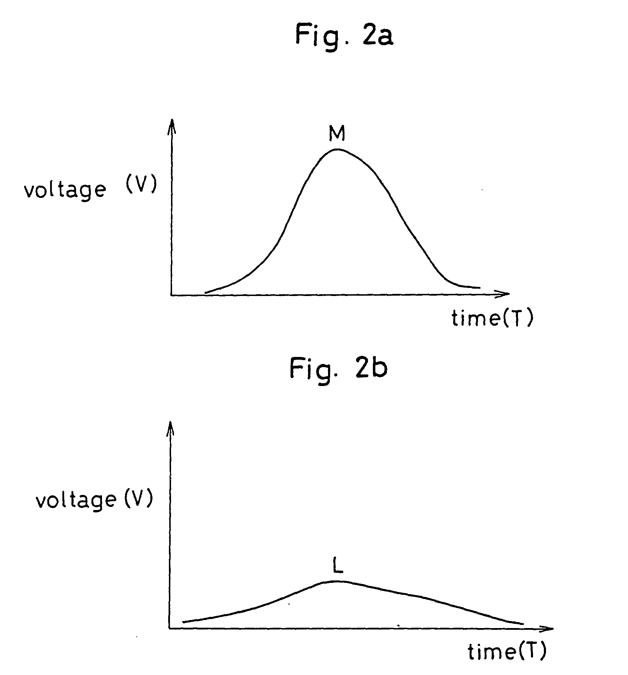

Upon running the internal combustion engine, a spark plug ignites an air-fuel mixture vapor injected into the cylinder of the internal combustion engine in accordance with an ignition timing determined depending on the running condition of the internal combustion engine. When the air-fuel mixture vapor is normally ignited in the cylinder of the internal combustion engine, ionized particles in the combustion gas decreases an electrical resistance of the ion current gap G to break down its electrical insulation so as to permit an ion current flowing through the ion current gap G. In this moment, an electrically live path is formed from the current power source 30 to the ground S by way of the electrode 3, the ion current gap G, the electrode 4 and the resistor 5, and thus permitting a high level ion current flowing therethrough. As shown at M in Fig. 2a, the ion current is detected in variation of voltage by a voltage detector circuit 6 through a divider circuit provided by the resistor 5 and a resistor R of the ion current gap G.

When the spark plug fails to ignite the air-fuel mixture vapor due to malfunction of its ingnition circuit or an insufficient spark discharge of the spark plug, substantially no ion current is permitted to flow through the ion current gap G due to an absence or insufficient presence of the ionized particles in the air-fuel mixture vapor. As a result, the voltage detector circuit 6 detects a low level ion current flowing through the ion current gap G as shown at L in Fig. 2b.

That is to say, it is possible to detect a misfire in the cylinder of the internal combustion engine depending on whether or not the ion current level is more than a predetermined threshold. It is noted that it is possible to recognize a burning condition in the cylinder of the internal combustion engine by detecting a rising-up curve, a rising-down curve, a sustaining time length, an integral curve value, or a time length duration required to reach a predetermined level characteristic of the graphical representation shown in Figs. 2a, 2b.

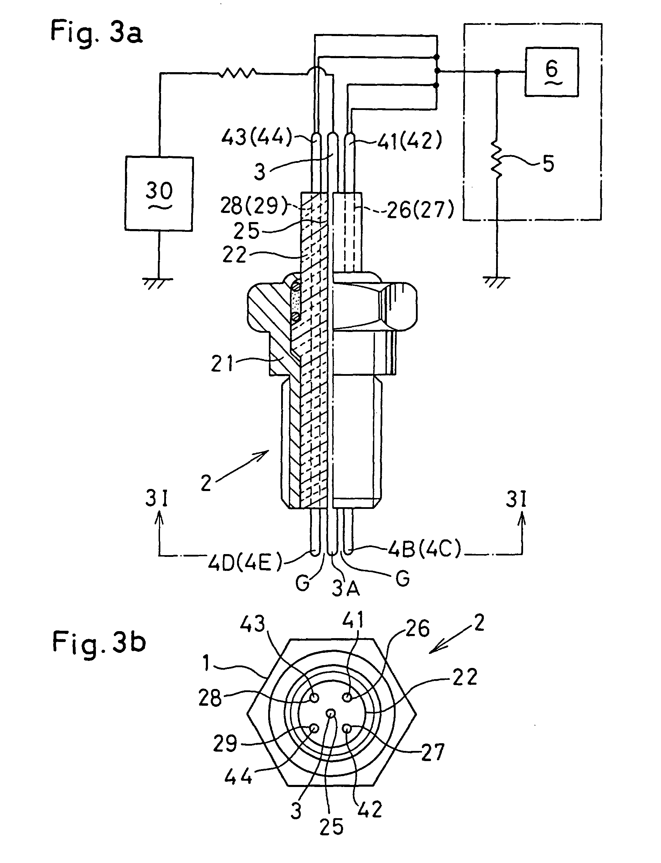

Figs. 3a and 3b show a first embodiment of the invention in which an elongated insulator 22 has a central bore 25, and circumferentially having a plurality of axial bores 26 ∼ 29 with the bore 25 as a center. The ion voltage electrode 3 is firmly placed in the central bore 25, while ion current detector electrodes 41 ∼ 44 are solidly placed in the axial bores 26 ∼ 29 respectively. The number of the ion current detector electrodes is chosen at discretion such as two, three, five or more. The ion current gap G is defined between the front end 3A of the electrode 3 and front ends 4B ∼ 4E of the electrodes 41 ∼ 44. In this instance, the ion current detector electrodes 41 ∼ 44 may be provided in an insulator 22 in the metallic shell 21, otherwise they may be provided in another ion plug discrete from the ion plug 2 in which the ion voltage electrode 3 is placed.

In so doing, it is possible to detect the direction in which the combustion flames spread in the cylinder of the internal combustion engine by multiplying the number of the ion current detector electrodes 41 ∼ 44. Further, the added number of the electrodes 41 ∼ 44 makes it possible to increase chances which enable to detecting the ion current, and thus enhancing the ion current detection accuracy when the ionized particles is not ubiquitously present around the ion current detector electrodes 41 ∼ 44 by the combustion condition.

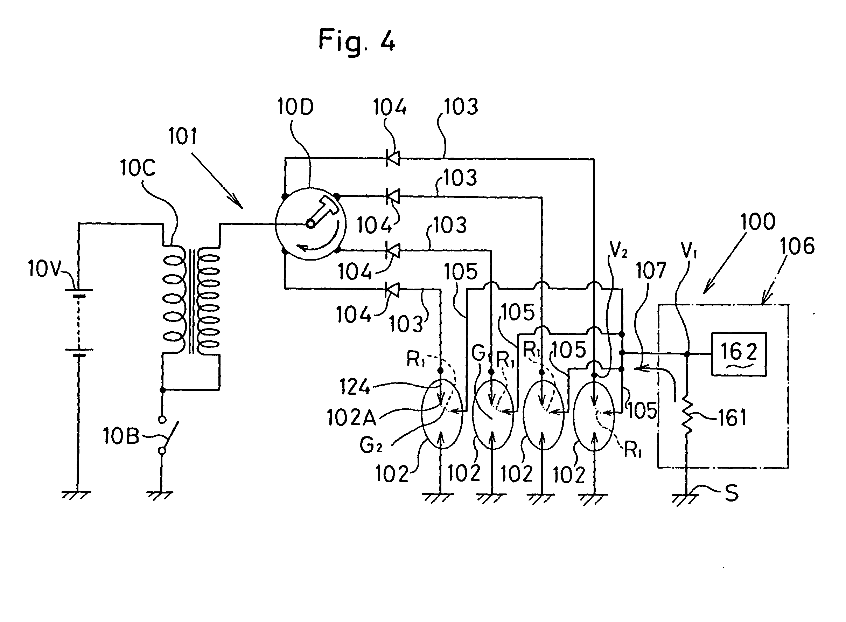

Fig. 4 shows an example, not according to the invention, but given to assist understanding of a second embodiment. Fig. 4 shows an example in which an ion current detector device 100 is incorporated into an ignition circuit 101 for an internal combustion engine. Numeral 10C designates an ignition coil which steps up a primary voltage supplied from a vehicular battery cell 10V to establish a spark plug voltage. Numeral 10B designates a primary current on-off interrupter device used for the ignition coil 10C. Numeral 10D is a distributor through which the spark plug voltage is applied to a spark plug 102 mounted on a cylinder head of the internal combustion engine. A spark plug voltage circuit 103 is provided to electrically connect the distributor 10D to the spark plug 102. A high voltage diode 104 is provided between the distributor 10D and the spark plug 102 so as to prevent a current flowing back toward the distributor 10D.

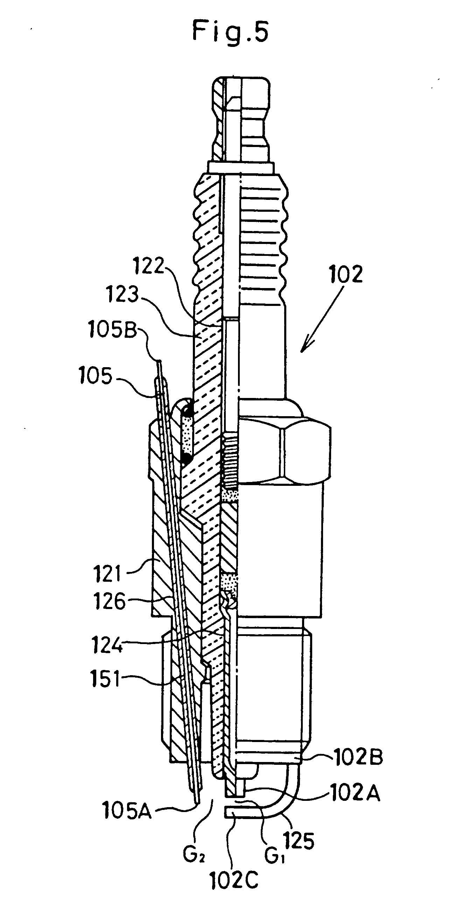

Meanwhile, the spark plug 102 has a metallic shell 121 in which a tubular insulator 123 is fixedly placed as shown in Fig. 5. Within an axial bore 122 of the insulator 123, a center electrode 124 is placed whose front end 102A forms a spark gap G1 with a front end 102C of a L-shaped ground electrode 125 welded to a front end surface 102B of the metallic shell 121. A bore 126 is provided in the metallic shell 121 somewhat slantwisely against its axial direction. Within the bore 126, an ion current detector electrode 105 is tightly placed which is coated by an insulation film 151. Between a front end 105A of the electrode 105 and the front end 102A of the center electrode 124, an ion current gap G2 is formed which is greater in width than the spark gap G1. The ion current detector device 100 includes the ion current detector electrode 105 and an ion current detector circuit 106 connected between a rear end 105B of the ion current detector electrode 105 and the ground S. The ion current detector circuit 106 has a resistor 161 and a voltage detector circuit 162 which detects a voltage change between the resistor 161 and the rear end 105B of the ion current detector electrode 105.

Upon operating the ignition circuit 101 to keep running the internal combustion engine, the primary current on-off interrupter device 10B induces the spark plug voltage (10,000 V or more) in the spark plug voltage circuit 103 which is equivalent to a secondary circuit of the ignition coil 10C. The spark plug voltage is supplied to a point V2 of the center electrode 124 of the spark plug 102 by way of the distributor 10D and the high voltage diode 104.

This causes to establish a spark discharge at the spark gap G1 so as to ignite an air-fuel mixture vapor injected into the cylinder of the internal combustion engine. Upon normally igniting the air-fuel mixture vapor, the presence of the ionized particles in the combustion gas makes it possible to drop an electrical resistance R1 of the ion current gap G2 to break down its insulation so as to permit an ion current flowing through the gap G2.

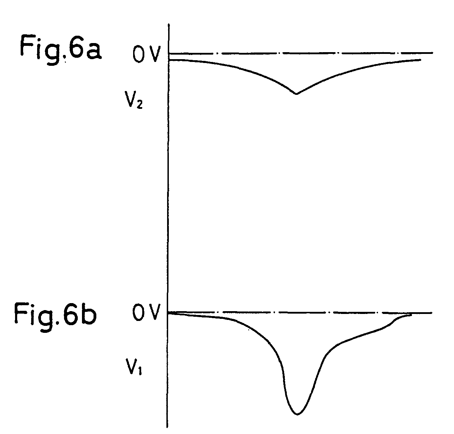

In this moment, an electrically live path is formed from the ground S to the center electrode 124 by way of the resistor 161, the electrode 105, the ion current gap G2, and thus permitting a high level ion current flowing in the direction of an arrow 107 shown in Fig. 4. As shown in Fig. 6b, the high level ion current is detected at a point V1 in term of voltage by the voltage detector circuit 162 through a divider circuit provided by the resistor 161 and a resistor R1 of the ion current gap G2.

The spark plug voltage is in the side of relatively stable negative polarity caused from an early stage of an inductive discharge subsequent to a capacitive discharge when the high voltage is applied to the center electrode in the side of negative polarity. However, the spark plug voltage is likely to fluctuate before the start and after an end of the spark discharge between the electrodes 124, 125, and thus oscillating the ion current to change its polarity. As a result, an accurate ion current detection is possible only during a short period at the time of around the ignition. The provision of the high voltage diode 104 makes it possible to eliminate a reverse polarity voltage of the oscillating spark plug voltage so as to enable to an accurate ion current detection after the end of the spark discharge between the electrodes 124, 125.

When the spark plug fails to ignite the air-fuel mixture vapor due to malfunction of its ingnition circuit or an insufficient spark discharge of the spark plug, substantially no ion current is permitted to flow through the ion current gap G2 due to an absence or insufficient presence of the ionized particles in the air-fuel mixture vapor. As a result, the voltage detector circuit 162 detects a low level ion current flowing through the ion current gap G2 as shown in Fig. 6a.

That is to say, it is possible to detect a misfire in the cylinder of the internal combustion engine depending on whether or not the ion current level is more than a predetermined threshold. It is noted that it is possible to recognize the burning conditions in the cylinder of the internal combustion engine by detecting a rising-up curve, a rising-down curve, a sustaining time length, an integral curve value, or a time length duration required to reach a predetermined level characteristic of the graphical representation shown in Figs. 6a, 6b.

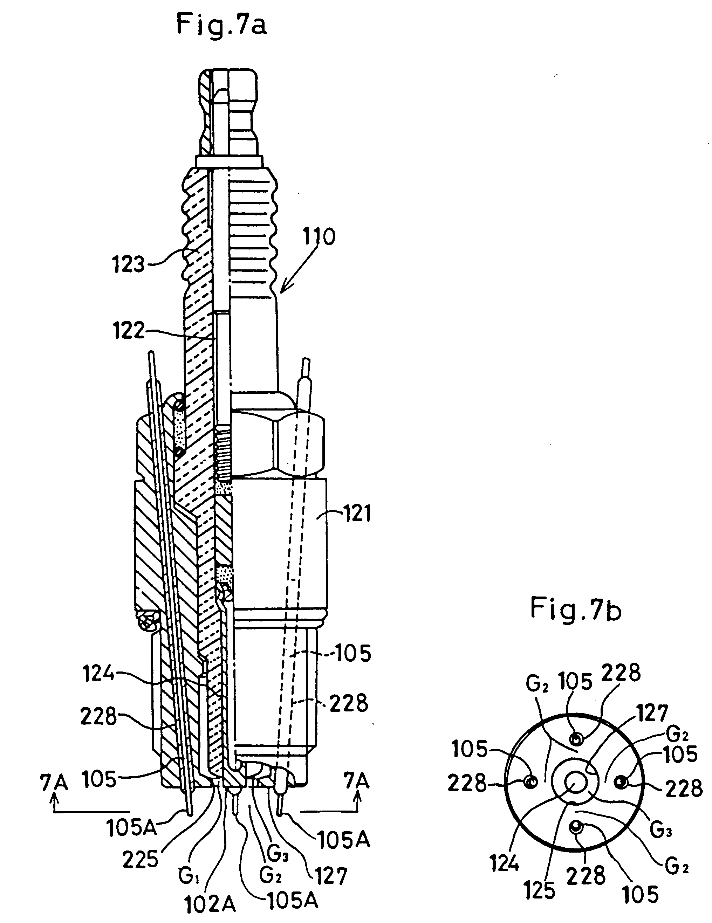

Figs. 7a and 7b show a second embodiment of the invention in which a spark plug 110 has an annular ground electrode 225 provided at an front end 127 of the metallic shell 121 instead of the L-shaped ground electrode 125. This arrangement makes it possible to form a semi-creeping spark discharge gap G3 between an inner wall of the ground electrode 225 and the front end 102A of the center electrode 124. Four bores are provided in the metallic shell 121 slightly oblique against its axial direction as designated by numeral 228. In each of the four bores 228, the ion current detector electrode 105 is firmly placed to define the ion current gap G2 between the front end 102A of the center electrode 124 and the front end 105A of the ion current detector electrode 105. In this instance, the ion current detector electrode 105 may be provided in the insulator 123 instead of the metallic shell 121.

Thus the added number of the ion current detector electrodes makes it possible to increase chances which enable to detecting the ion current, and enhancing the ion current detection accuracy when the ionized particles is ubiquitously maldistributed present around the ion current detector electrode 105 by the combustion condition.

It is appreciated that a changing rate of the voltage may be detected by the ion current detector circuit 106 instead of merely measuring the peak voltage.

While the invention has been described with reference to the specific embodiments, it is understood that this description is not to be construed in a limiting sense in as such as various modifications and additions to the specific embodiments may be made by skilled artisan without departing from the scope of the invention as defined by the appended claims.

## Claims

1. An ion current detector device for an internal combustion engine, comprising:
an ion voltage electrode (3; 124) provided so that in use its front end (3A; 102A) is exposed to an inside of a cylinder or an exhaust passage of an internal combustion engine;
an ion current power source (30; 101) which is connected to the ion voltage electrode (3; 124); and
an ion current detector circuit (5, 6; 106),
**characterised in that**:
a plurality of ion current detector electrodes (41-44; 105) are circumferentially arranged with the ion voltage electrode (3; 124) at a central portion, and forming ion current gaps (G; G₂) with the front end (3A; 102A) of the ion voltage electrode (3; 124); and
wherein said ion current detector circuit (5, 6; 106) is connected between said ion current detector electrodes (41-44; 105) and ground (S), and comprises a voltage detector circuit (6; 162) provided between the ion current detector electrodes (41-44; 105) and a resistor (5; 161) which is connected between each ion current detector electrode (41-44; 105) and the ground (S), so as to detect an intensity of current flowing through the resistor (5; 161) and the ion current detector electrodes (41-44; 105).

2. An ion current detector device for an internal combustion engine according to claim 1, wherein the ion current detector electrodes (105) are provided in a spark plug (110) slantwisely with respect to a center electrode (124), the front ends (105A) of the ion current detector electrodes (105) forming ion current gaps (G₂) with a front end (102A) of the center electrode (124).

3. An ion current detector device according to claim 2, wherein a diode (104) is connected between the center electrode (124) of the spark plug (110) and an ignition circuit (101) so as to prevent a reverse polarity spark plug voltage affecting ion current detection.

4. An ion current detector device according to any one of the preceding claims, wherein said ion voltage electrode (124) is the center electrode (124) of a spark plug (110) to be connected to an ignition circuit (101) which acts as said ion current power source, the spark plug being for location in a cylinder of an internal combustion engine.

5. An ion current detector device according to any one of the preceding claims, wherein said plurality of ion current detector electrodes (41-44; 105) comprises four ion current detector electrodes (41-44; 105).

## Patentansprüche

1. Ionenstrom-Detektorvorrichtung für einen Verbrennungsmotor, umfassend:
eine Ionenspannungselektrode (3; 124), die derart vorgesehen ist, daß im Betrieb ihr vorderes Ende (3A; 102A) zu dem Inneren eines Zylinders oder eines Abgaskanals eines Verbrennungsmotors hin freiliegt;
eine Ionenstrom-Energiequelle (30; 101), die an die Ionenspannungselektrode (3; 124) angeschlossen ist; und
eine Ionenstrom-Detektorschaltung (5, 6; 106),
**dadurch gekennzeichnet, daß**
mehrere Ionenstrom-Detektorelektroden (41-44; 105) über einen Umfang mit der Ionenspannungselektrode (3; 124) in einem mittleren Bereich angeordnet sind und Ionenstromspalte (G; G₂) im Verein mit dem vorderen Ende (3A, 102A) der Ionenspannungselektrode (3; 124) bilden; und
die Ionenstrom-Detektorschaltung (5, 6; 106) zwischen die Ionenstrom-Detektorelektroden (41-44; 105) und Masse (S) gelegt ist und eine Spannungsdetektorschaltung (6; 162) zwischen den Ionenstrom-Detektorelektroden (41-44; 105) und einem Widerstand (5; 161) aufweist, wobei letzterer zwischen jeder Ionenstrom-Detektorelektrode (41-44; 105) und Masse (S) liegt, um eine Stärke des durch den Widerstand (5; 161) und die Ionenstrom-Detektorelektroden (41-44; 105) fließenden Stroms zu erfassen.

2. Ionenstrom-Detektorvorrichtung für einen Verbrennungsmotor nach Anspruch 1, bei der die Ionenstrom-Detektorelektrode (105) in Schräglage bezüglich einer Mittelelektrode (124) innerhalb einer Zündkerze (110) vorgesehen sind, wobei die vorderen Enden (105A) der Ionenstrom-Detektorelektroden (105) Ionenstromspalte (G₂) im Verein mit einem vorderen Ende (102A) der Mittelelektrode (124) bilden.

3. Ionenstrom-Detektorvorrichtung nach Anspruch 2, bei der eine Diode (104) zwischen die Mittelelektrode (124) der Zündkerze (110) und eine Zündschaltung (101) gelegt ist, um zu verhindern, daß eine Zündkerzenspannung umgekehrter Polarität die Ionenstromerfassung abträglich beeinflußt.

4. Ionenstrom-Detektorvorrichtung nach einem der vorhergehenden Ansprüche, bei der die Ionenspannungselektrode (124) die Mittelelektrode (124) einer Zündkerze (110) ist, die an eine Zündschaltung (101) anzuschließen ist, welche als die erwähnte Ionenstrom-Energiequelle fungiert, wobei die Zündkerze zur Unterbringung in einen Zylinder einer Verbrennungsmaschine vorgesehen ist.

5. Ionenstrom-Detektorvorrichtung nach einem der vorhergehenden Ansprüche, bei der die mehreren Ionenstrom-Detektorelektroden (41-44; 105) vier Ionenstrom-Detektorelektroden (41-44; 105) aufweisen.

## Revendications

1. Dispositif détecteur de courant ionique pour moteur à combustion interne, comprenant:
une électrode (3; 124) de tension ionique disposée de façon que, en fonctionnement, son extrémité avant (3A; 102A) soit exposée à l'intérieur d'un cylindre ou d'un passage d'échappement d'un moteur à combustion interne ;
une source (30; 101) d'énergie de courant ionique connectée à l'électrode (3; 124) de tension ionique ; et
un circuit de détection (5, 6; 106) de courant ionique,
**caractérisé en ce que** :
une pluralité d'électrodes (41-44; 105) de détection de courant ionique sont disposées de manière circonférentielle, l'électrode (3; 124) de tension ionique étant en position centrale, et formant des entrefers (G; G₂) pour courant ionique avec l'extrémité avant (3A; 102A) de l'électrode (3; 124) de tension ionique ; et
dans lequel ledit circuit de détection (5, 6; 106) de courant ionique est connecté entre lesdites électrodes (41-44; 105) de détection de courant ionique et la terre (S) et comporte un circuit (6; 162) de détection de tension disposé entre les électrodes (41-44; 105) de détection de courant ionique et une résistance (5; 161) qui est connectée entre chaque électrode (41-44; 105) de détection de courant ionique et la terre (S) de façon à détecter l'intensité du courant passant dans la résistance (5; 161) et les électrodes (41-44; 105) de détection de courant ionique.

2. Dispositif détecteur de courant ionique pour moteur à combustion interne selon la revendication 1, dans lequel les électrodes (105) de détection de courant ionique sont disposées dans une bougie d'allumage (110), de manière oblique par rapport à une électrode centrale (124), les extrémités avant (105A) des électrodes (105) de détection de courant ionique formant des entrefers (G₂) pour courant ionique avec une extrémité avant (102A) de l'électrode centrale (124).

3. Dispositif détecteur de courant ionique selon la revendication 2, dans lequel une diode (104) est connectée entre l'électrode centrale (124) de la bougie d'allumage (110) et un circuit d'allumage (101) de façon à empêcher une tension de bougie d'allumage à polarité inverse d'affecter la détection de courant ionique.

4. Dispositif détecteur de courant ionique selon l'une quelconque des revendications précédentes, dans lequel ladite électrode (124) de tension ionique est l'électrode centrale (124) d'une bougie d'allumage (110) à connecter à un circuit d'allumage (101) qui constitue ladite source d'énergie de courant ionique, la bougie d'allumage étant destinée à être placée dans un cylindre de moteur à combustion interne.

5. Dispositif détecteur de courant ionique selon l'une quelconque des revendications précédentes, dans lequel ladite pluralité d'électrodes (41-44; 105) de détection de courant ionique comporte quatre électrodes (41-44; 105) de détection de courant ionique.
